# FASCICULE DE BREVET EUROPEEN

(11) **EP 3 421 872 B1**
(45) Date de publication et mention de la délivrance du brevet: **11.01.2023**
(21) Numéro de dépôt: 18179654.1
(22) Date de dépôt: 25.06.2018
(51) Int. Cl.: F21S 41/141, F21S 43/14, B60Q 1/00, F21V 23/00, F21V 23/02, F21S 41/19, H05K 9/00

(54) **DISPOSITIF D'ÉCLAIRAGE POUR VÉHICULE AUTOMOBILE MUNI D'UN FAISCEAU ÉLECTRIQUE GUIDÉ**
BELEUCHTUNGSVORRICHTUNG FÜR KRAFTFAHRZEUG, DIE MIT EINEM GEFÜHRTEN KABELSTRANG AUSGESTATTET IST
LIGHTING DEVICE FOR A MOTOR VEHICLE COMPRISING A GUIDED WIRING HARNESS

(30) Priorité: 29.06.2017 FR 1756074
(43) Date de publication de la demande: 02.01.2019
(73) Titulaire: Valeo Vision Belgique, 7822 Meslin l'Evêque (BE)
(72) Inventeur: HERBIN, Cyril, B-7822 MESLIN L'EVEQUE (BE); DELGRANGE, Frédérick, B-7822 Meslin l'Evêque (BE)
(74) Mandataire: Valeo Visibility

(56) Documents cités:
- EP-A1- 2 266 845
- EP-A1- 2 360 424
- EP-A1- 2 848 860
- EP-A1- 3 109 537
- DE-A1- 19 704 067
- DE-A1-102009 018 445
- FR-A1- 3 032 516
- JP-A- 2006 302 714
- JP-A- 2014 135 158
- US-A1- 2017 009 954

## Description

### Domaine technique de l'invention

La présente invention concerne un dispositif d'éclairage pour véhicule automobile. L'invention concerne également un véhicule automobile comprenant un tel dispositif d'éclairage. L'invention concerne également un procédé de montage d'un tel dispositif d'éclairage dans un véhicule automobile.

### État de la technique

Les véhicules automobiles comportent un nombre croissant d'équipements électriques ou électroniques réalisant différentes fonctions. Le fonctionnement d'un équipement électrique ou électronique génère des perturbations électromagnétiques pouvant provoquer des dysfonctionnements des autres équipements. Pour cette raison, des seuils maximum d'émissions d'ondes électromagnétiques sont imposés à chaque équipement électrique ou électronique. Il existe également des seuils de perturbations sur les câbles alimentant l'équipement afin d'éviter des dysfonctionnements sur les autres équipements utilisant la même source d'alimentation. En particulier, les dispositifs d'éclairage d'un véhicule automobile doivent satisfaire certains critères d'émission d'ondes électromagnétiques et d'émissions conduites sur les câbles d'alimentation.

Les dispositifs d'éclairage doivent en outre répondre à des exigences d'esthétisme. Ces exigences peuvent se traduire par un choix particulier de source de lumière comme par exemple des diodes électroluminescentes, une disposition particulière des sources de lumière au sein du dispositif d'éclairage. De plus, afin d'augmenter le confort d'utilisation, un même dispositif d'éclairage doit pouvoir fonctionner selon plusieurs modes d'éclairage se différenciant par exemple par l'intensité d'éclairage ou l'activation de différentes sources de lumière à l'intérieur du dispositif d'éclairage. Enfin, les dispositifs d'éclairage sont soumis à des exigences d'encombrement afin d'utiliser le moins d'espace possible dans le véhicule.

Le document JP2014135158 décrit un dispositif d'éclairage pour un véhicule automobile, comprenant un boîtier, un circuit imprimé muni d'au moins une diode électroluminescente, et muni d'une cage de blindage électromagnétique, et un faisceau électrique fixé par une première extrémité au circuit imprimé et fixé par une deuxième extrémité au boîtier.

### Objet de l'invention

Le but de l'invention est de fournir un dispositif d'éclairage et un procédé de montage du dispositif d'éclairage permettant d'atteindre de manière optimale aux exigences mentionnées ci-dessus des dispositifs d'éclairage et des procédés de montage connus de l'art antérieur. En particulier, l'invention permet de réaliser un dispositif et un procédé de montage du dispositif qui soient simples à mettre en œuvre.

A cet effet, l'invention se rapporte à un dispositif d'éclairage pour un véhicule automobile, comprenant :
- un boîtier,
- un circuit imprimé muni d'au moins une source lumineuse, notamment une source lumineuse de type diode électroluminescente, et muni d'une cage de blindage électromagnétique, le circuit imprimé s'étendant selon un plan de circuit imprimé et étant fixé à l'intérieur du boîtier,
- un faisceau électrique fixé par une première extrémité au circuit imprimé et fixé par une deuxième extrémité au boîtier,
le faisceau électrique comprenant un cheminement dont la projection selon un axe perpendiculaire au plan de circuit imprimé n'intersecte pas la projection de la cage selon l'axe perpendiculaire au plan de circuit imprimé et le faisceau électrique comprenant une portion s'étendant le long de la cage, notamment parallèlement à un bord latéral de la cage.

Le boîtier peut comprendre au moins une nervure destinée à guider le cheminement du faisceau électrique à l'intérieur du boîtier.

L'au moins une nervure peut former avec le boîtier un ensemble monobloc, notamment un ensemble monobloc réalisé en plastique injecté.

Le boîtier peut comprendre deux nervures destinées à guider le cheminement du faisceau à l'intérieur du boîtier, le boîtier comprenant un fond s'étendant selon un plan sensiblement parallèle au plan de circuit imprimé, une première nervure s'étendant depuis le fond du boîtier parallèlement à l'axe perpendiculaire au plan de circuit imprimé, le boîtier comprenant un bord latéral s'étendant selon un plan sensiblement perpendiculaire au plan de circuit imprimé, une deuxième nervure s'étendant depuis le bord latéral du boîtier parallèlement au plan de circuit imprimé.

Le faisceau électrique peut comprendre un blindage électromagnétique, notamment un tore de ferrite.

Le dispositif d'éclairage peut comprendre un ensemble optique arrière comprenant au moins un collimateur, notamment un collimateur de type Fresnel, et un ensemble optique avant, distinct de l'ensemble optique arrière, doté d'une face avant comprenant au moins deux surfaces d'éclairage transverses disposées à différents niveaux dans la direction longitudinale pour former au moins deux marches d'une forme globale en escalier, l'ensemble optique avant étant empilé en contact direct avec l'ensemble optique arrière.

L'ensemble optique arrière et l'ensemble optique avant peuvent se présenter chacun en une seule pièce monobloc comprenant au moins chacun un moyen de maintien.

L'invention se rapporte également à un véhicule automobile comprenant un dispositif d'éclairage tel que défini précédemment.

Enfin, l'invention se rapporte également à un procédé de montage d'un dispositif d'éclairage tel que défini précédemment comprenant les étapes suivantes :
a) Fabrication d'un circuit imprimé muni d'une cage de blindage électromagnétique et muni d'au moins une source lumineuse, notamment une source lumineuse de type diode électroluminescente ;
b) Fabrication d'un faisceau électrique ;
c) Fabrication d'un boîtier muni d'une première nervure et d'une deuxième nervure, notamment fabrication du boîtier par injection plastique ;
d) Fixation d'une première extrémité du faisceau électrique au boîtier (6) ;
e) Fixation d'une deuxième extrémité du faisceau électrique au circuit imprimé (22) ;
f) Positionnement du faisceau électrique entre une première nervure et un bord latéral du boîtier, et/ou
g) Positionnement du faisceau électrique entre une deuxième nervure et un fond du boîtier.
h) Fixation du circuit imprimé à l'intérieur du boîtier.

L'étape « f » peut être réalisée après l'étape « d » et après l'étape « e ».

L'étape « g » peut être réalisée après l'étape « d » et après l'étape « e ».

L'étape « h » peut être réalisée après l'étape « f » et après l'étape « g ».

### Description sommaire des dessins

Ces objets, caractéristiques et avantages de la présente invention seront exposés en détail dans la description suivante d'un mode de réalisation particulier fait à titre non-limitatif en relation avec les figures jointes parmi lesquelles :
La figure 1 est une vue schématique de face d'un véhicule automobile selon un mode de réalisation de l'invention.
La figure 2 est une vue de face d'un projecteur du véhicule selon un mode de réalisation de l'invention.
La figure 3 est une vue schématique de dessus du projecteur selon une coupe longitudinale et transversale.
La figure 4 est une vue schématique en coupe d'un coté du projecteur
La figure 5 est une vue de l'arrière du projecteur.
La figure 6 est une vue en perspective d'un tore de ferrite entourant le faisceau électrique selon un mode de réalisation alternatif de l'invention.
La figure 7 est une première vue schématique d'un circuit imprimé et d'un faisceau électrique selon une configuration ne correspondant pas à l'invention.
La figure 8 est une deuxième vue schématique d'un circuit imprimé et d'un faisceau électrique selon un mode de réalisation de l'invention.
La figure 9 est une vue partielle du projecteur comprenant un boîtier, un faisceau électrique et une cage de blindage électromagnétique selon un mode de réalisation de l'invention.
La figure 10 est une vue partielle du boîtier.
La figure 11 est un graphe de mesure d'émissions conduites d'un projecteur dans un premier mode d'éclairage, le projecteur étant muni d'un faisceau électrique dans une première configuration ne correspondant pas à l'invention.
La figure 12 est un graphe de mesure d'émissions conduites d'un projecteur dans un deuxième mode d'éclairage, le projecteur étant muni d'un faisceau électrique dans une première configuration ne correspondant pas à l'invention.
La figure 13 est un graphe de mesure d'émissions conduites du projecteur dans un premier mode d'éclairage, le projecteur étant muni d'un faisceau électrique selon un mode de réalisation de l'invention.
La figure 14 est un graphe de mesure d'émissions conduites du projecteur dans un deuxième mode d'éclairage, le projecteur étant muni d'un faisceau électrique selon un mode de réalisation de l'invention.

### Description de modes préférentiels de l'invention

Sur l'ensemble des figures et de la description, on définit un repère lié à un véhicule automobile. La gauche et la droite sont définies selon le point de vue d'un conducteur. L'axe X désigne l'axe longitudinal du véhicule. En marche avant et en ligne droite, le véhicule progresse de l'arrière vers l'avant selon une direction parallèle à son axe longitudinal. L'axe X est orienté de l'avant vers l'arrière du véhicule, c'est-à-dire dans le sens de la marche arrière. L'axe Y désigne l'axe transversal du véhicule. L'axe Y est orienté de la gauche vers la droite. L'axe Z désigne l'axe perpendiculaire à l'axe X et à l'axe Y. L'axe Z est un axe vertical lorsque le véhicule repose sur un sol horizontal. L'axe Z est orienté de bas en haut. Les axes X, Y et Z forment un repère orthonormé direct. L'axe longitudinal X est donc perpendiculaire au plan vertical et transversal YZ. Sur l'ensemble des figures et de la description, on considère que le véhicule repose sur un sol horizontal. Ce même repère pourra être utilisé pour décrire un dispositif d'éclairage même considéré hors du véhicule puisqu'il est destiné être monté selon une orientation particulière dans le véhicule.

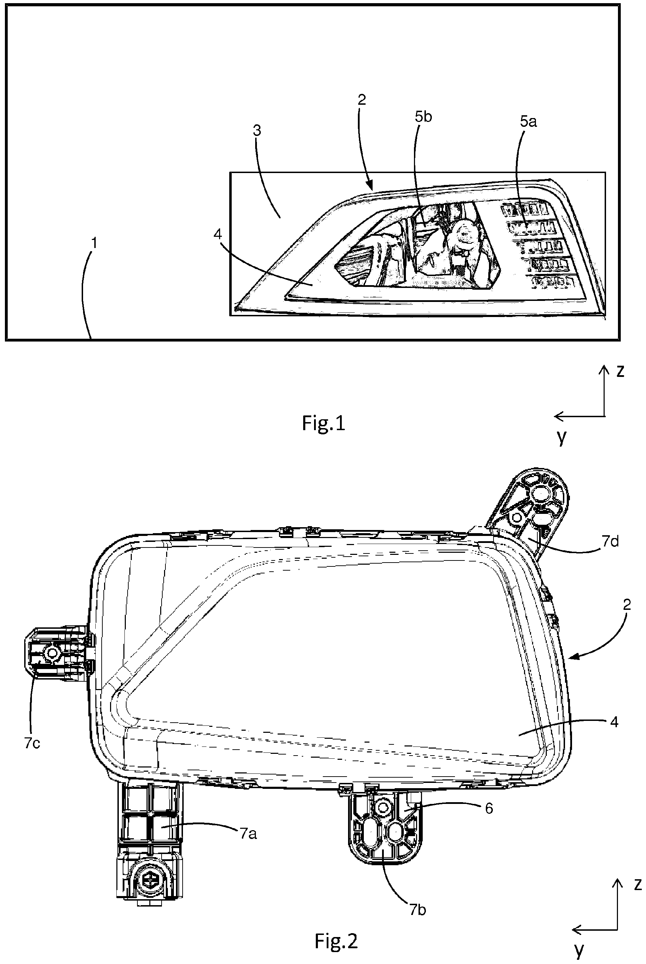

La figure 1 illustre schématiquement un véhicule 1 automobile muni d'un dispositif d'éclairage 2 selon un mode de réalisation de l'invention. Le dispositif d'éclairage est un projecteur et pourra être dénommé ainsi dans la suite du document. Le projecteur illustré est le projecteur avant gauche. Le véhicule peut également comprendre un projecteur avant droit réalisé symétriquement à droite du véhicule et/ou un ou plusieurs projecteurs à l'arrière du véhicule équipés d'un mode de réalisation de l'invention. Le véhicule pourrait également être un camion, un bus, un véhicule industriel, une moto ou tout autre type de véhicule muni d'un projecteur. Afin de simplifier la description, nous allons décrire le projecteur avant gauche. Cette description pourrait aisément être transposée à un projecteur avant droit, à un projecteur arrière droit ou à un projecteur arrière gauche.

Le projecteur peut comprendre un feu de position, un feu de croisement, un feu de route, un feu de brouillard, un clignotant ou tout autre source de lumière contribuant à l'éclairage du véhicule et/ou à l'éclairage de la route. Vu de face, le projecteur a une forme globalement trapézoïdale avec une grande base sensiblement horizontale vers le bas et une petite base également sensiblement horizontale et vers le haut mais le projecteur pourrait avoir toute autre forme. Le projecteur est fixé à une caisse du véhicule et peut être entouré par une carrosserie 3 du véhicule. Le projecteur comprend une face frontale 4 translucide ou transparente le protégeant des agressions extérieures. Selon le mode de réalisation présenté le projecteur comprend deux compartiments 5a, 5b positionnés côte-à-côte. Un premier compartiment 5a peut comprendre par exemple un éclairage de type feu de position ou feu de croisement ou feu d'éclairage diurne. Un deuxième compartiment 5b, positionné à droite du premier compartiment 5a, peut comprendre par exemple un éclairage de type feu de route ou feu de brouillard.

La figure 2 illustre schématiquement le projecteur hors du véhicule. Le projecteur comprend un boîtier 6 sur lequel est fixée la face frontale 4. Le boîtier 6 comprend des moyens de fixations pour la fixation au véhicule. En l'occurrence, le boîtier comprend quatre pattes de fixation 7a, 7b, 7c, 7d. Deux pattes de fixation 7a, 7b s'étendent verticalement depuis un bord inférieur du projecteur. Une troisième patte de fixation 7c s'étend depuis un bord latéral vers la droite. Une quatrième patte de fixation 7d s'étend depuis un coin supérieur gauche vers le haut et vers la gauche. Ainsi le projecteur peut être rigidement fixé au véhicule, notamment à la caisse du véhicule.

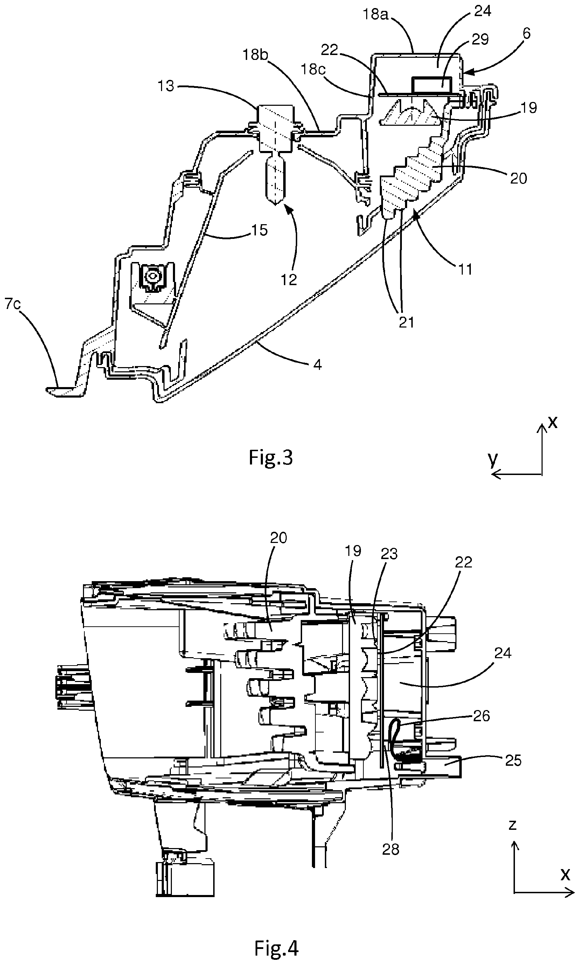

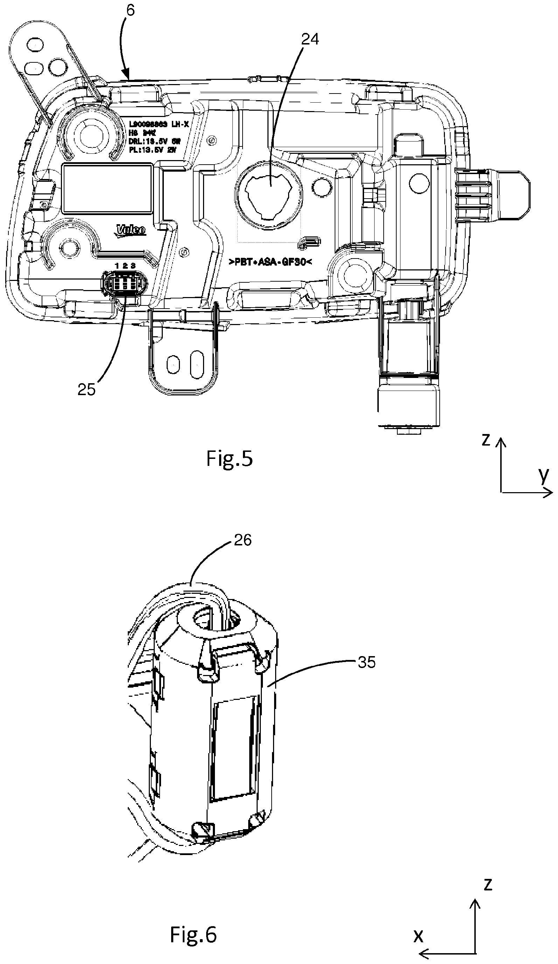

La figure 3 illustre une vue en coupe et du dessus du projecteur. Le premier compartiment 5a comprend un premier module optique 11 selon un mode de réalisation de l'invention. Le deuxième compartiment comprend un deuxième module optique 12. Le deuxième module optique comprend une source lumineuse, en l'occurrence une ampoule 13, par exemple de type H8. L'ampoule peut être par exemple une ampoule halogène ou une ampoule à diodes électroluminescentes. L'ampoule est fixée au travers d'une ouverture 14 réalisée dans un fond du boîtier. Une telle ouverture est particulièrement visible sur la figure 5. En outre le deuxième module optique 12 comprend des surfaces réfléchissantes 15 formant un entonnoir autour de l'ampoule et s'étendant jusqu'à la face frontale 4. La face frontale est commune au premier et au deuxième module optique. La face frontale s'étend selon un plan comprenant grossièrement l'axe vertical Z et un axe oblique par rapport à l'axe transversal Y.

Le boîtier 6 est généralement un boîtier réalisé à partir de plastique injecté. Le boîtier forme une enveloppe fermée vers l'avant par la face frontale 4. Le boîtier peut comprendre une ou plusieurs chicanes d'étanchéité à l'interface avec la face frontale. Selon le mode de réalisation représenté, le boîtier est une pièce monobloc en plastique enveloppant le premier et le deuxième module optique. Le boîtier comprend une paroi commune 17 entre le premier et le deuxième module optique. Le boîtier comprend un premier fond 18a à l'arrière du premier module optique et un deuxième fond 18b à l'arrière du deuxième module optique. Le premier et le deuxième fond s'étendent selon des plans parallèles à l'axe vertical Z et à l'axe transversal Y. Le premier fond est décalé par rapport au deuxième fond. Le premier fond est positionné d'avantage vers l'arrière que le deuxième fond. En variante, le projecteur pourrait ne comprendre qu'un seul module optique ou plus de deux modules optiques. Le projecteur pourrait également comprendre un boîtier propre à chaque module optique.

Par la suite, le premier module optique sera dénommé plus simplement « le module optique » et le « premier fond » sera dénommé plus simplement « le fond ». Le module optique est notamment visible selon une coupe en perspective sur la figure 4. Le module optique 11 comprend une partie du boîtier 6 dans laquelle est logé un circuit imprimé 22 muni d'au moins une source lumineuse 23, un ensemble optique avant 20 et un ensemble optique arrière 19. L'ensemble optique arrière 19 comprend au moins un collimateur, notamment un collimateur de type Fresnel. L'ensemble optique avant 20 est distinct de l'ensemble optique arrière.

L'ensemble optique avant est doté d'une face avant comprenant au moins deux surfaces d'éclairage 21 transverses disposées à différents niveaux dans la direction longitudinale pour former au moins deux marches d'une forme globale en escalier. L'ensemble optique avant est empilé en contact direct avec l'ensemble optique arrière. L'ensemble optique arrière et l'ensemble optique avant se présentent chacun en une seule pièce monobloc comprenant au moins chacun un moyen de maintien au boîtier.

Le circuit imprimé s'étend selon un plan de circuit imprimé YZ parallèlement au fond 18a du boîtier. C'est-à-dire, le circuit imprimé s'étend sensiblement parallèlement à l'axe vertical Z et à l'axe transversal Y. Un volume 24 est délimité entre le fond 18a, le circuit imprimé et des bords latéraux du boîtier. Un bord latéral 18c droit est positionné dans le prolongement de la paroi commune 17.

L'au moins une source lumineuse peut être au moins une diode électroluminescente. Préférentiellement, le module optique comprend un ensemble de diodes électroluminescentes. Le module optique peut être apte à produire différents modes d'éclairage. Par exemple, un premier mode d'éclairage peut correspondre à un feu de position et un deuxième mode d'éclairage peut correspondre à un feu d'éclairage diurne. Les différents modes d'éclairage peuvent se distinguer par le nombre de diodes électroluminescentes activées, la position des diodes électroluminescentes activées, ou encore la puissance lumineuse délivrée par chaque diode électroluminescente.

Comme particulièrement visible sur la figure 4, un premier connecteur 25 traverse le fond du boîtier selon un axe sensiblement parallèle à l'axe X.

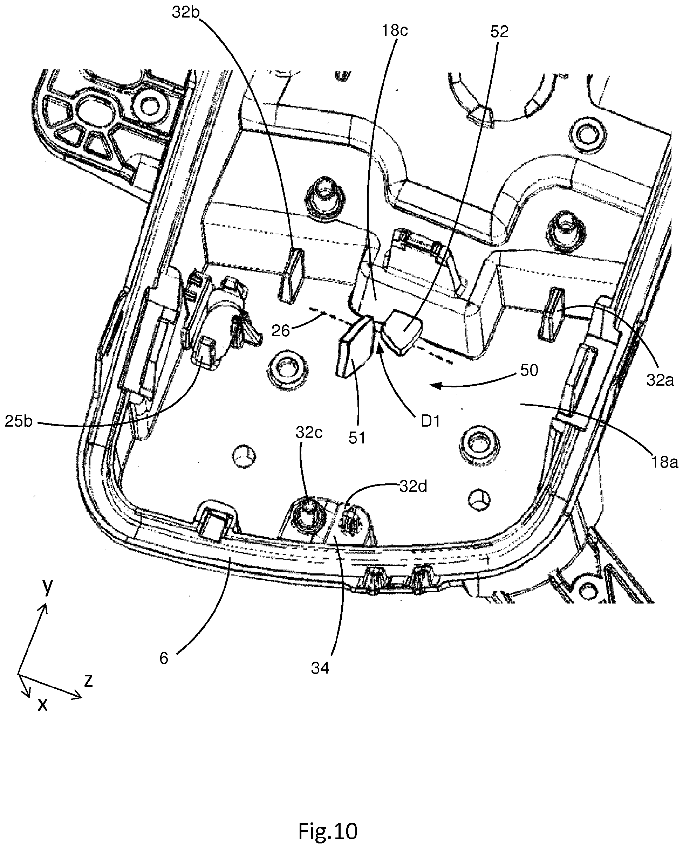

Le premier connecteur comprend une première partie positionnée à l'extérieur du boîtier destinée à être connecté à un faisceau électrique secondaire. Le premier connecteur est un élément distinct du boîtier. Le premier connecteur est fixé au boîtier par un moyen d'encliquetage 25b particulièrement visible sur la figure 10. Ainsi, le projecteur peut être connecté électriquement à d'autres organes du véhicule, notamment à une unité de commande électronique, et/ou à un dispositif d'alimentation électrique. Le premier connecteur comprend également une deuxième partie positionnée à l'intérieur du boîtier et relié à un faisceau électrique 26. Le faisceau électrique 26 comprend une première extrémité reliée au premier connecteur 25 et une deuxième extrémité reliée au circuit imprimé par l'intermédiaire d'un deuxième connecteur 28. En variante, le dispositif lumineux pourrait ne pas comprendre de connecteur ou comprendre un seul connecteur. Par exemple les câbles du faisceau électrique pourraient être soudés sur le circuit imprimé ou encore le faisceau électrique pourrait simplement traverser le boîtier, par exemple au travers d'un passe fil, et être relié à l'extérieur du boîtier à d'autres organes du véhicule.

Le premier connecteur est orienté suivant l'axe longitudinal X et traverse le fond du boîtier. Le premier connecteur est situé à proximité du coin inférieur droit du boîtier. Le deuxième connecteur est également orienté suivant l'axe longitudinal X sur le circuit imprimé. Le deuxième connecteur est situé à proximité du coin inférieur droit du circuit imprimé. Le premier connecteur et le deuxième connecteur sont donc positionnés très proches l'un de l'autre lorsque le circuit imprimé est assemblé au boîtier. La distance séparant le premier connecteur du deuxième connecteur est nettement inférieure à la longueur du faisceau électrique. On peut faire remarquer que si la longueur du faisceau électrique avait été limitée à la distance séparant le premier connecteur du deuxième connecteur, l'assemblage du premier connecteur au boîtier et/ou du deuxième connecteur au circuit imprimé serait impossible. En effet, il n'y aurait pas assez d'espace entre le circuit imprimé et le boîtier pour réaliser ces connexions.

Le faisceau électrique comprend trois câbles électriques de même longueur. La longueur minimale du faisceau électrique peut être définie de sorte à pouvoir fixer sans difficulté le premier connecteur au boîtier et/ou le deuxième connecteur au circuit imprimé lors de l'assemblage du module optique. La longueur maximale du faisceau peut être définie pour optimiser la quantité de câble mise en œuvre. Les câbles électriques ne sont pas fixés entre eux mais sont tous trois reliés par une première extrémité au premier connecteur et par une deuxième extrémité au circuit imprimé. Les câbles électriques peuvent être des fils métalliques entourés d'une gaine isolante. Par ailleurs, Le faisceau électrique pourrait comprendre tout autre nombre de câbles électrique supérieur ou égal à un.

En variante, le faisceau électrique pourrait également comprendre un tore de ferrite 35 tel que représentée sur la figure 6. Le tore de ferrite comprend un solide de révolution métallique muni d'une ouverture centrale par laquelle passe le faisceau électrique. Le tore de ferrite peut prendre par exemple la forme d'un anneau ou encore d'un cylindre muni d'une ouverture centrale cylindrique. Le tore de ferrite peut comprendre deux demi-cylindres articulés par une charnière de manière à pouvoir s'ouvrir pour le montage autour du faisceau électrique. Ainsi le tore ferrite n'a pas besoin d'être enfilé par une extrémité du faisceau électrique pour être assemblée au faisceau électrique. En variante, le tore de ferrite pourrait n'entourer qu'une partie des câbles du faisceau électriques

Selon une autre variante, éventuellement complémentaire de la précédente, le faisceau électrique pourrait comprendre une gaine enveloppant, au moins localement, l'ensemble des câbles afin que le cheminement de chaque câble soit parallèle au cheminement des autres câbles. La gaine pourrait également comprendre un blindage électromagnétique par exemple sous la forme d'une tresse métallique entourant l'ensemble des câbles.

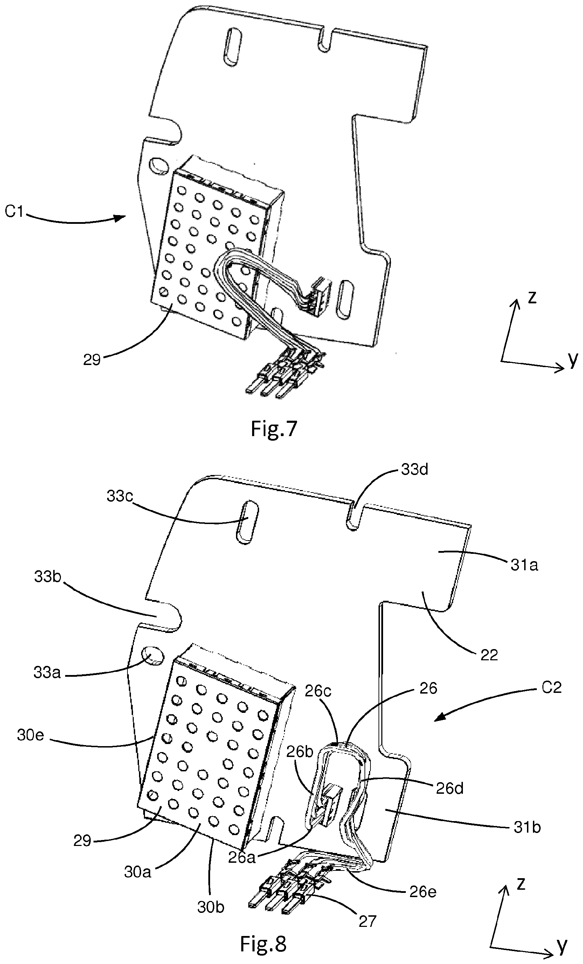

Le circuit imprimé comprend une première face sur laquelle est fixée l'au moins une source lumineuse 23. L'ensemble optique arrière est positionné contre la première face du circuit imprimé. La première face est tournée vers l'avant du véhicule. Le circuit imprimé comprend une deuxième face, tournée vers l'arrière, sur laquelle est fixé le faisceau électrique. Le faisceau électrique peut être connecté à la deuxième face du circuit imprimé par l'intermédiaire de fiches 27 métalliques disposées à l'extrémité de chaque câble du faisceau insérées dans le deuxième connecteur 28. Ces fiches sont particulièrement visibles sur les figures 7 et 8. Les fiches sont orientées suivant l'axe longitudinal X. Les fiches sont connectées au circuit imprimé par l'intermédiaire du deuxième connecteur fixé sur la deuxième face arrière du circuit imprimé. La deuxième face du circuit imprimé comprend également un ensemble de composants électroniques constituant un pilote pour l'alimentation, notamment un convertisseur de puissance de type hacheur comprenant une bobine. Les composants électroniques peuvent également constituer un pilote pour le pilotage de l'au moins une source lumineuse. Ces composants électroniques ainsi que les pistes qui les relient entre eux sont principalement responsable des émissions. Ces composants électroniques sont entourés par une cage 29 de blindage électromagnétique, également dénommée cage de Faraday. Le circuit imprimé peut également comprendre d'autres composants électroniques à l'extérieur de la cage sur la première face ou sur la deuxième face du circuit imprimé. On précise que le connecteur 28 n'est pas à l'intérieur de la cage 29. Le faisceau électrique ne traverse donc pas la cage.

La cage, particulièrement visible sur les figures 7 et 8 peut avoir une forme globalement parallélépipédique. La cage est positionnée en bas du circuit imprimé, à gauche du deuxième connecteur. La cage peut avoir une longueur de plus grande dimension qu'une largeur et la largeur de plus grande dimension qu'une hauteur. La longueur est sensiblement orientée suivant l'axe vertical Z. La largeur est sensiblement orientée suivant l'axe transversal Y. La hauteur de la cage est sensiblement orientée suivant l'axe longitudinal X. Ainsi, on peut distinguer une face arrière 30a de la cage s'étendant selon un plan sensiblement parallèle au plan du circuit imprimé. On peut également distinguer un coté latéral inférieur 30b, un coté latéral supérieur 30c, un coté latéral droit 30d et un côté latéral gauche 30e. En variante, la cage pourrait avoir toute autre forme, par exemple une forme cylindrique ou une forme polygonale. La cage est généralement réalisée à partir de feuilles d'acier, ou de tout autre matériau conducteur. Les feuilles d'acier peuvent être percées de trous circulaires régulièrement répartis comme c'est le cas ici sur la face arrière 30a.

La forme du circuit imprimé peut épouser, au moins grossièrement, la forme du boîtier. Ainsi, selon le mode de réalisation présenté, le circuit imprimé a une forme globalement rectangulaire avec un premier prolongement 31a vers la droite depuis un coin supérieur droit du circuit imprimé et avec un deuxième prolongement 31b vers la droite depuis un coin inférieur droit du circuit imprimé. Le bord latéral 18c droit du boîtier comprend un profil épousant le profil du bord droit du circuit imprimé. Le boîtier ayant une forme complémentaire du circuit imprimé, on peut ainsi s'assurer que le circuit imprimé est correctement orienté dans le boîtier. En particulier, un assemblage du circuit imprimé dans le boîtier avec une rotation d'un quart de tour serait impossible.

Le boîtier comprend également des piliers 32a, 32b, 32c, 32d s'étendant parallèlement à l'axe longitudinal X et permettant de définir précisément la position du circuit imprimé à l'intérieur du boîtier. Le circuit imprimé peut être en appui sur un premier pilier 32a par l'intermédiaire d'un premier prolongement 31a. Le circuit imprimé peut être en appui sur un deuxième pilier 32b par l'intermédiaire d'un deuxième prolongement 31b. Le circuit imprimé peut également comporter des ouvertures 33a, 33b, notamment des ouvertures oblongues ou circulaires. Une première ouverture 33a peut coopérer avec un troisième pilier 32c et une deuxième ouverture 33b peut coopérer avec un quatrième pilier 32d pour bloquer la position du circuit imprimé par rapport à l'axe vertical Z et par rapport à l'axe transversal Y. Le troisième pilier 32c et le quatrième pilier 32d peuvent également servir à fixer l'ensemble optique arrière 19 et l'ensemble optique avant 20 sur le boîtier. D'autres ouvertures 33c, 33d réalisées dans le circuit imprimé peuvent servir à fixer l'ensemble optique arrière 19 contre le circuit imprimé. Le circuit imprimé peut également être en appui sur le socle 34 commun au troisième et quatrième pilier. Le premier pilier, le deuxième pilier et le socle forment trois points d'appui pour le circuit imprimé et définissent ainsi le plan de circuit imprimé. Ainsi, La position du circuit imprimé par rapport au boîtier est complètement définie. La position et l'orientation de l'au moins une source lumineuse est précise.

Le faisceau électrique est contenu dans le volume 24. En l'absence d'un moyen de guidage, le faisceau électrique pourrait suivre un cheminement quelconque à l'intérieur du volume 24. Le cheminement du faisceau électrique peut être régi par la position du premier et du deuxième connecteur ainsi que par la rigidité des câbles composant le faisceau électrique. Ainsi, dans une première configuration C1, un cheminement du faisceau électrique peut être illustré sur la figure 7. On remarque que le faisceau passe derrière la cage. La projection du faisceau selon l'axe longitudinal X intersecte la projection de la cage selon l'axe longitudinal X. Le faisceau réalise une boucle en forme de « U » lorsqu'il passe derrière la cage. Malgré la cage 29 de blindage électromagnétique, une partie de la puissance rayonnée par les composants électroniques à l'intérieur de la cage atteint le faisceau créant des perturbations conduites dans le faisceau qui devient alors une antenne et produit des perturbations électromagnétiques

Pour une configuration donnée du faisceau et pour un mode d'éclairage donné, on peut mesurer le rayonnement électromagnétique émis par le module optique. Une telle mesure peut être réalisée par exemple suivant une norme internationale ou suivant une norme d'un constructeur automobile définissant les seuils d'émissions électromagnétiques acceptables. On peut représenter la puissance du champ électromagnétique en fonction de sa fréquence sur un graphique logarithmique. Plus précisément, on peut représenter d'une part une mesure correspondant à une moyenne temporelle de la puissance du champ électromagnétique en fonction de la fréquence. On peut représenter d'autre part, une mesure correspondant à une valeur de crête ou une valeur de quasi crête de la puissance du champ électromagnétique en fonction de la fréquence. La norme internationale ou la norme du constructeur automobile définit des seuils maximum de puissance de champ électromagnétique en fonction de la fréquence. La norme internationale ou la norme du constructeur automobile définit également des seuils maximum de tension en fonction de la fréquence pour les émissions conduites.

Le confinement des dispositifs d'éclairage ainsi que les contraintes de positionnement ou encore la nature des sources de lumière rendent les seuils d'émission d'ondes électromagnétiques plus difficiles à respecter.

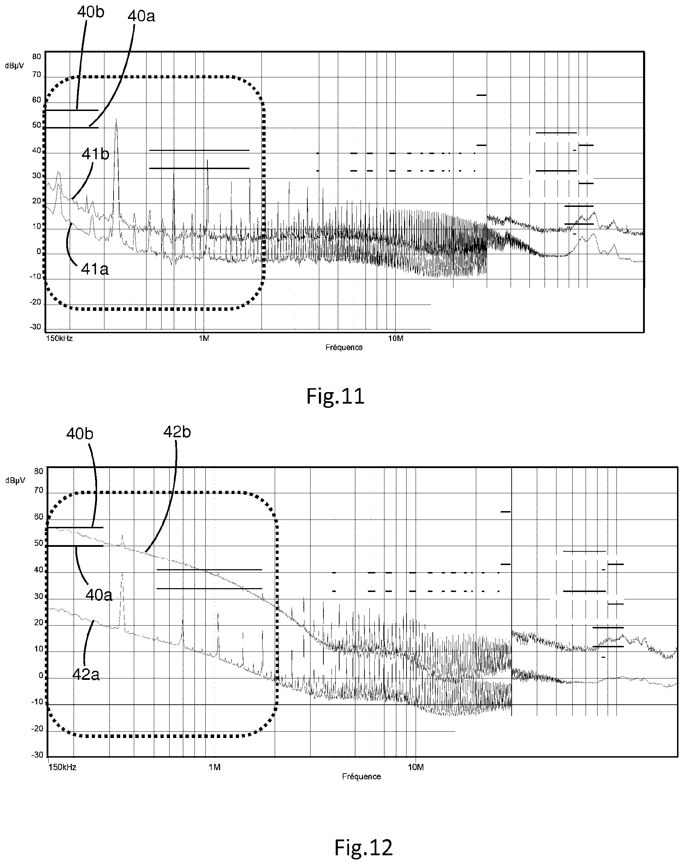

Ainsi, la figure 11 représente un graphique de la tension moyenne 41a et de la tension en crête 41b des émissions conduites du module optique sur une bande de fréquence comprise entre 150kHz et 200 MHz pour le premier mode d'éclairage et avec la première configuration du faisceau électrique. Le graphique comprend également les seuils maximum pour les niveaux de tension moyens 40a et pour les niveaux de tension crête 40b définis par la norme internationale ou par la norme du constructeur automobile. On constate que les émissions conduites dépassent les seuils définis par la norme, notamment pour une bande de fréquence aux alentours de 1.1 MHz.

De même, la figure 12 représente un graphique de la tension moyenne 42a et de la tension en crête 42b des émissions conduites du module optique sur une bande de fréquence comprise entre 150kHz et 200 MHz pour le deuxième mode d'éclairage et avec la première configuration du faisceau électrique. Le graphique comprend également les seuils maximum pour les niveaux de tension moyens 40a et pour les niveaux de tension crête 40b définis par la norme internationale ou par la norme du constructeur automobile. On constate que les émissions conduites dépassent les seuils définis par la norme, notamment pour une bande de fréquence aux alentours de 530 KHz.

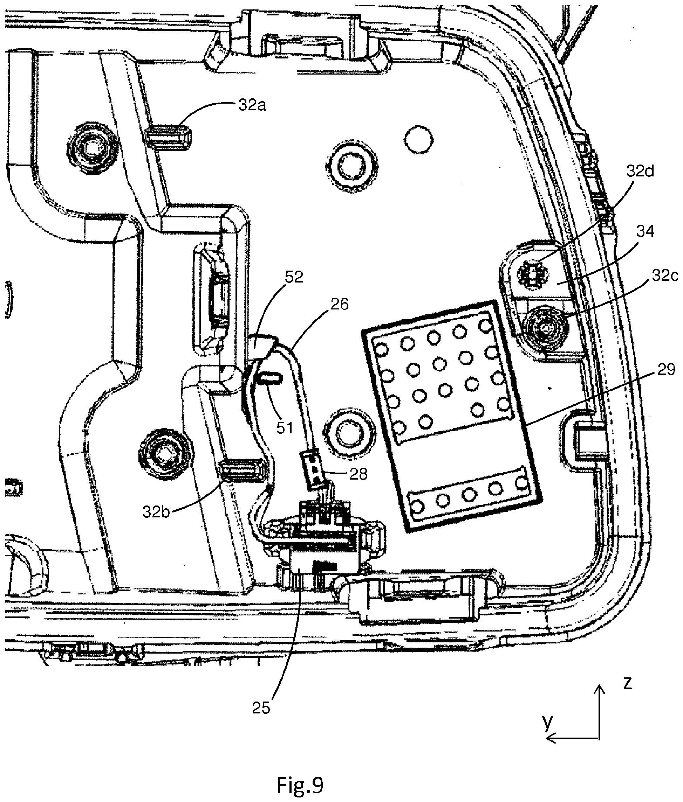

On constate qu'en modifiant le cheminement du faisceau électrique à l'intérieur du volume 24, le spectre d'émission électromagnétique du module optique est également modifié. On peut définir une deuxième configuration C2 du cheminement du faisceau électrique, dans laquelle la projection du faisceau selon l'axe longitudinal X n'intersecte pas la projection de la cage selon l'axe longitudinal X mais longe le bord latéral droit 30d de la cage. La deuxième configuration est particulièrement visible sur la figure 8 et sur la figure 9. Sur la figure 9, le circuit imprimé a été rendu invisible afin de permettre la visualisation du cheminement du faisceau électrique par rapport à la cage. En considérant le cheminement du faisceau électrique depuis le deuxième connecteur, c'est-à-dire le connecteur fixé au circuit imprimé, jusqu'au premier connecteur, c'est-à-dire le connecteur fixé au boîtier, on peut distinguer différents tronçons du faisceau électrique, différenciés par des changements de direction du faisceau électrique. Les changements de direction peuvent être par exemple des courbures d'angle environ égal à 90°. Dans un premier tronçon 26a, le faisceau électrique émerge perpendiculairement au plan de circuit imprimé YZ. Dans un deuxième tronçon 26b, le faisceau électrique monte vers le haut en longeant le bord latéral droit 30d de la cage parallèlement au plan de circuit imprimé. Dans un troisième tronçon 26c, le faisceau électrique est orienté de gauche à droite parallèlement au plan de circuit imprimé. Dans ce troisième tronçon, le faisceau électrique s'éloigne de la cage, mais en variante, il pourrait également s'en rapprocher sans toutefois passer derrière la cage. Dans un quatrième tronçon 26d, le faisceau électrique descend vers le bas en longeant le bord latéral 18c droit du boîtier, parallèlement au plan de circuit imprimé. Enfin, dans un cinquième er dernier tronçon, le faisceau électrique est orienté perpendiculairement au plan de circuit imprimé pour déboucher dans le premier connecteur. Ainsi, le faisceau est replié sur lui-même et ne dessine pas une boucle derrière la cage pouvant être couplée avec le champ magnétique de la bobine principale du convertisseur de puissance. Le faisceau électrique est éloigné de la cage et ne dessine pas de boucle perpendiculaire aux lignes de champ électromagnétique en provenance de la cage. L'aire de la projection du faisceau électrique selon l'axe longitudinal X est beaucoup plus faible que pour la première configuration C1 du cheminement du faisceau électrique. En variante le faisceau pourrait longer tout autre bord latéral de la cage.

Afin d'obtenir un cheminement du faisceau électrique selon la deuxième configuration un moyen de guidage 50 du faisceau est intégré au boîtier. En particulier, le moyen de guidage peut être intégré au fond du boîtier et au bord latéral droit du boîtier, au niveau d'une portion du faisceau s'étendant suivant l'axe vertical Z, le long du bord droit de la cage. Le moyen de guidage 50 est particulièrement illustré sur les figures 9 et10.

A cet effet le boîtier comprend une première nervure 51 s'étendant depuis le fond 18a du boîtier parallèlement à l'axe perpendiculaire au plan de circuit imprimé. La première nervure s'étend donc suivant l'axe longitudinal X depuis le fond du boîtier. Le première nervure a une forme globalement rectangulaire et s'étend également parallèlement à l'axe transversal Y. La première nervure est positionnée environ à mi hauteur du fond du boîtier suivant l'axe vertical Z et à proximité du bord latéral 18c droit du boîtier. Un premier espace dans lequel le faisceau électrique est logé sépare la première nervure du bord latéral droit. Le faisceau électrique passe entre la première nervure 51 et le bord latéral 18c droit. Ainsi, la première nervure réalise un maintien du faisceau électrique suivant l'axe transversal Y.

Le boîtier comprend également une deuxième nervure 52 s'étendant depuis le bord latéral 18c droit du boîtier parallèlement au plan de circuit imprimé. La deuxième nervure s'étend donc suivant l'axe transversal Y et suivant l'axe vertical Z. Le deuxième nervure a une forme globalement rectangulaire et est positionnée environ à mi hauteur du bord latéral du boîtier entre le fond du boîtier et le circuit imprimé suivant l'axe longitudinal X. Un deuxième espace dans lequel le faisceau électrique est logé sépare la deuxième nervure du fond. Le faisceau électrique passe entre la deuxième nervure 52 et le fond 18a du boîtier. Ainsi, la deuxième nervure réalise un maintien du faisceau électrique suivant l'axe longitudinal X. La deuxième nervure est positionnée en vis-à-vis de la premier nervure. Un espace D1 sépare la première nervure de la deuxième nervure permettant le passage du faisceau électrique lors du montage. L'espace peut être ajusté en fonction de l'épaisseur du faisceau pour permettre de le faire passer entre les deux nervures. Le montage du faisceau électrique entre les deux nervures peut nécessiter une déformation locale des nervures ou du faisceau afin de garantir une retenue efficace du faisceau électrique une fois mis en place.

En variante, le boîtier pourrait ne comprendre qu'une seule nervure parmi la première ou la deuxième nervure. Une nervure pourrait comprendre une encoche destinée à recevoir le faisceau. Le boîtier pourrait comprendre également d'avantage de nervures et d'autres moyens de guidage du faisceau répartis tout au long de son cheminement.

Préférentiellement, la première et la deuxième nervure sont réalisées d'un seul bloc avec le boîtier lors d'une même opération d'injection plastique. A cet effet, le moule d'injection peut comprendre des tiroirs permettant de réaliser les nervures. Par exemple, le moule d'injection peut comprendre un tiroir mobile selon l'axe transversal Y. En variante la première nervure et/ou la deuxième nervure pourraient être des éléments fabriqués séparément et fixés (par exemple encliquetés ou collés) sur le boîtier.

On peut alors mesurer les émissions électromagnétiques du module optique lorsque le cheminement du faisceau électrique est dans la deuxième configuration.

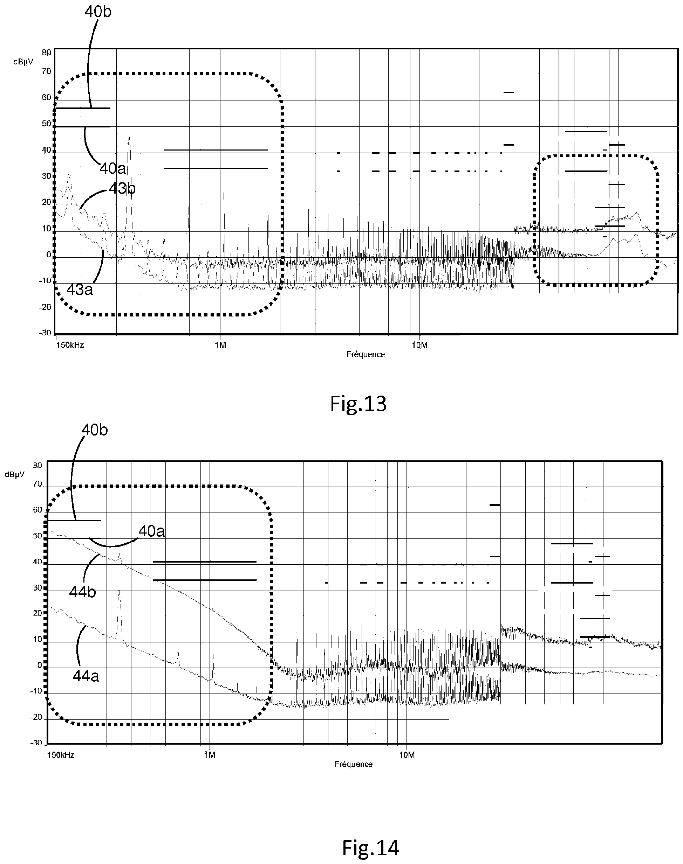

La figure 13 représente un graphique de la tension moyenne 43a et de la tension en crête 43b des émissions conduites du module optique sur une bande de fréquence comprise entre 150kHz et 200 MHz pour le premier mode d'éclairage et avec la deuxième configuration du faisceau. Le graphique comprend également les seuils maximum pour les niveaux de tension moyens 40a et pour les niveaux de tension crête 40b définis par la norme internationale ou par la norme du constructeur automobile. On constate que les émissions conduites respectent les seuils définis par la norme.

De même, la figure 14 représente un graphique de la tension moyenne 44a et de la tension en crête 44b des émissions conduites du module optique sur une bande de fréquence comprise entre 150kHz et 200 MHz pour le deuxième mode d'éclairage et avec la deuxième configuration du faisceau. Le graphique comprend également les seuils maximum pour les niveaux de tension moyens 40a et pour les niveaux de tension crête 40b définis par la norme internationale ou par la norme du constructeur automobile. On constate que les émissions conduites respectent les seuils définis par la norme.

L'invention se rapporte également à un procédé de montage d'un module optique comprenant les étapes suivantes référencées de « a » à « h ».
a) Dans une première étape, on fabrique le circuit imprimé muni de la source de lumière fixée sur la première face avant et muni de la cage de blindage électromagnétique fixée sur la deuxième face arrière du circuit imprimé. En variante la source de lumière pourrait être fixée au circuit imprimé dans une autre étape.
b) Dans une deuxième étape, on fabrique le faisceau électrique.
c) Dans une troisième étape, on fabrique le boîtier muni de la première nervure et de la deuxième nervure. En particulier la fabrication du boîtier peut être réalisée par injection de plastique dans un moule d'injection.
d) Dans une quatrième étape, on fixe la première extrémité du faisceau électrique au boîtier. En particulier cette opération peut consister en l'encliquetage du premier connecteur 25 sur le moyen d'encliquetage 25b.
e) Dans une cinquième étape, on fixe la deuxième extrémité du faisceau électrique au circuit imprimé. En particulier cette opération peut consister en l'insertion des fiches 27 du faisceau électrique dans le connecteur 28 fixé au circuit imprimé.
f) Dans une sixième étape, on positionne le faisceau électrique entre la première nervure et le bord du boîtier.
g) Dans une septième étape, on positionne le faisceau électrique entre la deuxième nervure et le fond du boîtier.

A l'issue de l'étape « f » et de l'étape « g » le faisceau électrique est positionné le long de la cage selon la deuxième configuration.
h) Dans une huitième étape, on fixe le circuit imprimé à l'intérieur du boîtier. En particulier cette étape comprend l'insertion des piliers 32c, 32d du boîtier dans les ouvertures 33a, 33b correspondantes du circuit imprimé. A l'issue de cette étape le faisceau est confiné dans le volume 24 rendu inaccessible par la fixation du circuit imprimé. Le risque que le faisceau électrique sorte de son guidage entre la première nervure et le bord du boîtier et entre la deuxième nervure et le fond du boîtier est donc très faible.

Préférentiellement les étapes du procédé de montage respectent l'ordre suivant :
- l'étape « f » peut être réalisée après l'étape « d » et après l'étape « e ».
- l'étape « g » peut être réalisée après l'étape « d » et après l'étape « e ».
- l'étape « h » est réalisée après l'étape « f » et après l'étape « g ».

Toutefois, il serait également possible de fixer au moins l'une des extrémités du faisceau après avoir fait passer le faisceau électrique entre la première nervure et le bord du boîtier et entre la deuxième nervure et le fond du boîtier.

Grâce à l'invention, on dispose d'un dispositif d'éclairage apte à réaliser plusieurs modes d'éclairage. L'encombrement de ce dispositif est limité et les émissions d'ondes électromagnétiques du dispositif permettent de l'intégrer dans un véhicule sans perturber le fonctionnement des autres organes électriques ou électroniques du véhicule. Le coût d'un tel dispositif d'éclairage reste modéré car il n'est pas utile de rajouter des composants onéreux pour limiter l'émission des ondes conduites.

## Revendications

1. Dispositif d'éclairage (11) pour un véhicule (1) automobile, comprenant :
- un boîtier (6),
- un circuit imprimé (22) muni d'au moins une source lumineuse (23), notamment une source lumineuse (23) de type diode électroluminescente, et muni d'une cage (29) de blindage électromagnétique, le circuit imprimé (22) s'étendant selon un plan de circuit imprimé (YZ) et étant fixé à l'intérieur du boîtier (6),
- un faisceau électrique (26) fixé par une première extrémité au circuit imprimé (22) et fixé par une deuxième extrémité au boîtier (6),
**caractérisé en ce que** le faisceau électrique (26) comprend un cheminement dont la projection selon un axe perpendiculaire (X) au plan de circuit imprimé (YZ) n'intersecte pas la projection de la cage (29) selon l'axe perpendiculaire (X) au plan de circuit imprimé (YZ) et **en ce que** le faisceau électrique (26) comprend une portion s'étendant le long de la cage (29), notamment parallèlement à un bord latéral (30d) de la cage (29).

2. Dispositif d'éclairage (11) selon la revendication précédente, **caractérisé en ce que** le boîtier (6) comprend au moins une nervure (51, 52) destinée à guider le cheminement du faisceau électrique (26) à l'intérieur du boîtier (6).

3. Dispositif d'éclairage (11) selon la revendication précédente, **caractérisé en ce que** l'au moins une nervure (51, 52) forme avec le boîtier (6) un ensemble monobloc, notamment un ensemble monobloc réalisé en plastique injecté.

4. Dispositif d'éclairage (11) selon l'une des revendications précédentes, **caractérisé en ce que** le boîtier (6) comprend deux nervures (51, 52) destinées à guider le cheminement du faisceau à l'intérieur du boîtier (6), le boîtier (6) comprenant un fond (18a) s'étendant selon un plan sensiblement parallèle au plan de circuit imprimé (YZ), une première nervure (51) s'étendant depuis le fond (18a) du boîtier (6) parallèlement à l'axe perpendiculaire au plan de circuit imprimé (YZ), le boîtier (6) comprenant un bord latéral (18c) s'étendant selon un plan sensiblement perpendiculaire au plan de circuit imprimé (YZ), une deuxième nervure s'étendant depuis le bord latéral (18c) du boîtier (6) parallèlement au plan de circuit imprimé (YZ).

5. Dispositif d'éclairage (11) selon l'une des revendications précédentes, **caractérisé en ce que** le faisceau électrique (26) comprend un blindage électromagnétique, notamment un tore de ferrite.

6. Dispositif d'éclairage (11) selon l'une des revendications précédentes, **caractérisé en ce qu'**il comprend un ensemble optique arrière (19) comprenant au moins un collimateur, notamment un collimateur de type Fresnel, et un ensemble optique avant (20), distinct de l'ensemble optique arrière (19), doté d'une face avant comprenant au moins deux surfaces d'éclairage (21) transverses disposées à différents niveaux dans la direction longitudinale (X) pour former au moins deux marches d'une forme globale en escalier, l'ensemble optique avant (20) étant empilé en contact direct avec l'ensemble optique arrière (19).

7. Dispositif d'éclairage (11) selon la revendication précédente, **caractérisé en ce que** l'ensemble optique arrière (19) et l'ensemble optique avant (20) se présentent chacun en une seule pièce monobloc comprenant au moins chacun un moyen de maintien.

8. Véhicule (1) automobile comprenant un dispositif d'éclairage (11) selon l'une des revendications précédentes.

9. Procédé de montage d'un dispositif d'éclairage (11) selon l'une des revendications 1 à 7 comprenant les étapes suivantes :
a. Fabrication d'un circuit imprimé (22) muni d'une cage (29) de blindage électromagnétique et muni d'au moins une source lumineuse (23), notamment une source lumineuse (23) de type diode électroluminescente ;
b. Fabrication d'un faisceau électrique (26) ;
c. Fabrication d'un boîtier (6) muni d'une première nervure (51) et d'une deuxième nervure (52), notamment fabrication du boîtier (6) par injection plastique ;
d. Fixation d'une première extrémité du faisceau électrique (26) au boîtier (6) ;
e. Fixation d'une deuxième extrémité du faisceau électrique (26) au circuit imprimé (22) ;
f. Positionnement du faisceau électrique (26) entre une première nervure (51) et un bord latéral (18c) du boîtier (6), et/ou
g. Positionnement du faisceau électrique (26) entre une deuxième nervure (52) et un fond (18a) du boîtier (6).
h. Fixation du circuit imprimé (22) à l'intérieur du boîtier (6).

10. Procédé de montage selon la revendication précédente, **caractérisé en ce que** :
- l'étape « f » est réalisée après l'étape « d » et après l'étape « e » ; et/ou
- l'étape « g » est réalisée après l'étape « d » et après l'étape « e » ; et/ou
- l'étape « h » est réalisée après l'étape « f » et après l'étape « g ».

## Patentansprüche

1. Beleuchtungsvorrichtung (11) für ein Kraftfahrzeug (1), umfassend:
- ein Gehäuse (6),
- eine Leiterplatte (22), die mit wenigstens einer Lichtquelle (23), insbesondere einer Lichtquelle (23) vom Typ Leuchtdiode, und mit einem Käfig (29) zur elektromagnetischen Abschirmung versehen ist, wobei sich die Leiterplatte (22) in einer Leiterplattenebene (YZ) erstreckt und im Inneren des Gehäuses (6) befestigt ist,
- einen Kabelbaum (26), der durch ein erstes Ende an der Leiterplatte (22) und durch ein zweites Ende am Gehäuse (6) befestigt ist,
**dadurch gekennzeichnet, dass** der Kabelbaum (26) einen Weg umfasst, dessen Projektion entlang einer Achse (X), die senkrecht zur Leiterplattenebene (YZ) verläuft, nicht die Projektion des Käfigs (29) entlang der Achse (X) schneidet, die senkrecht zur Leiterplattenebene (YZ) verläuft, und dadurch, dass der Kabelbaum (26) ein Teilstück umfasst, das sich entlang des Käfigs (29), insbesondere parallel zu einem Seitenrand (30d) des Käfigs (29) erstreckt.

2. Beleuchtungsvorrichtung (11) nach dem vorhergehenden Anspruch, **dadurch gekennzeichnet, dass** das Gehäuse (6) wenigstens eine Rippe (51, 52) umfasst, die dazu bestimmt ist, den Weg des Kabelbaums (26) im Inneren des Gehäuses (6) zu führen.

3. Beleuchtungsvorrichtung (11) nach dem vorhergehenden Anspruch, **dadurch gekennzeichnet, dass** die wenigstens eine Rippe (51, 52) mit dem Gehäuse (6) eine einstückige Anordnung bildet, insbesondere eine einstückige Anordnung, die aus spritzgegossenem Kunststoff gebildet ist.

4. Beleuchtungsvorrichtung (11) nach einem der vorhergehenden Ansprüche, **dadurch gekennzeichnet, dass** das Gehäuse (6) zwei Rippen (51, 52) umfasst, die dazu bestimmt sind, den Weg des Kabelbaums im Inneren des Gehäuses (6) zu führen, wobei das Gehäuse (6) einen Boden (18a) umfasst, der sich in einer Ebene erstreckt, die im Wesentlichen parallel zur Leiterplattenebene (YZ) verläuft, wobei sich eine erste Rippe (51) von dem Boden (18a) des Gehäuses (6) parallel zu der Achse erstreckt, die senkrecht zur Leiterplattenebene (YZ) verläuft, wobei das Gehäuse (6) einen Seitenrand (18c) umfasst, der sich in einer Ebene erstreckt, die im Wesentlichen senkrecht zur Leiterplattenebene (YZ) verläuft, wobei sich eine zweite Rippe von dem Seitenrand (18c) des Gehäuses (6) parallel zur Leiterplattenebene (YZ) erstreckt.

5. Beleuchtungsvorrichtung (11) nach einem der vorhergehenden Ansprüche, **dadurch gekennzeichnet, dass** der Kabelbaum (26) eine elektromagnetische Abschirmung umfasst, insbesondere einen Ferritkern.

6. Beleuchtungsvorrichtung (11) nach einem der vorhergehenden Ansprüche, **dadurch gekennzeichnet, dass** sie eine hintere optische Anordnung (19), die wenigstens einen Kollimator umfasst, insbesondere einen Fresnel-Kollimator, und eine vordere optische Anordnung (20), die von der hinteren optischen Anordnung (19) gesondert ist, umfasst, die mit einer Vorderseite versehen ist, die wenigstens zwei Beleuchtungsflächen (21) in Querrichtung umfasst, die auf verschiedenen Ebenen in der Längsrichtung (X) angeordnet sind, um wenigstens zwei Stufen einer allgemeinen Treppenform zu bilden, wobei die vordere optische Anordnung (20) in direktem Kontakt mit der hinteren optischen Anordnung (19) gestapelt ist.

7. Beleuchtungsvorrichtung (11) nach dem vorhergehenden Anspruch, **dadurch gekennzeichnet, dass** die hintere optische Anordnung (19) und die vordere optische Anordnung (20) jeweils einstückig ausgebildet sind, wobei sie wenigstens jeweils ein Haltemittel umfassen.

8. Kraftfahrzeug (1) umfassend eine Beleuchtungsvorrichtung (11) nach einem der vorhergehenden Ansprüche.

9. Verfahren zur Montage einer Beleuchtungsvorrichtung (11) nach einem der Ansprüche 1 bis 7 umfassend die folgenden Schritte:
a. Herstellen einer Leiterplatte (22), die mit einem Käfig (29) zur elektromagnetischen Abschirmung und mit wenigstens einer Lichtquelle (23), insbesondere einer Lichtquelle (23) vom Typ Leuchtdiode, versehen ist;
b. Herstellen eines Kabelbaums (26);
c. Herstellen eines Gehäuses (6), das mit einer ersten Rippe (51) und einer zweiten Rippe (52) versehen ist, insbesondere Herstellen des Gehäuses (6) durch Kunststoffspritzguss;
d. Befestigen eines ersten Endes des Kabelbaums (26) am Gehäuse (6);
e. Befestigen eines zweiten Endes des Kabelbaums (26) an der Leiterplatte (22);
f. Positionieren des Kabelbaums (26) zwischen einer ersten Rippe (51) und einem Seitenrand (18c) des Gehäuses (6),
und/oder
g. Positionieren des Kabelbaums (26) zwischen einer zweiten Rippe (52) und einem Boden (18a) des Gehäuses (6) .
h. Befestigen der Leiterplatte (22) im Inneren des Gehäuses (6).

10. Montageverfahren nach dem vorhergehenden Anspruch, **dadurch gekennzeichnet, dass**:
- der Schritt "f" nach dem Schritt "d" und nach dem Schritt "e" durchgeführt wird; und/oder
- der Schritt "g" nach dem Schritt "d" und nach dem Schritt "e" durchgeführt wird; und/oder
- der Schritt "h" nach dem Schritt "f" und nach dem Schritt "g" durchgeführt wird.

## Claims

1. Lighting device (11) for a motor vehicle (1), comprising:
- a housing (6),
- a printed circuit (22) provided with at least one light source (23), notably a light source (23) of light-emitting diode type, and provided with an electromagnetic shielding cage (29), the printed circuit (22) extending along a printed circuit plane (YZ) and being fixed inside the housing (6),
- an electrical cable harness (26) fixed by a first end to the printed circuit (22) and fixed by a second end to the housing (6),
**characterized in that** the electrical cable harness (26) has a run whose projection along an axis (X) at right angles to the printed circuit plane (YZ) does not intersect the projection of the cage (29) along the axis (X) at right angles to the printed circuit plane (YZ) and **in that** the electrical cable harness (26) comprises a portion extending along the cage (29), notably parallel to a lateral edge (30d) of the cage (29).

2. Lighting device (11) according to the preceding claim, **characterized in that** the housing (6) comprises at least one rib (51, 52) intended to guide the run of the electrical cable harness (26) inside the housing (6).

3. Lighting device (11) according to the preceding claim, **characterized in that** the at least one rib (51, 52) forms with the housing (6) a single-piece assembly, notably a single-piece assembly produced in injection-moulded plastic.

4. Lighting device (11) according to one of the preceding claims, **characterized in that** the housing (6) comprises two ribs (51, 52) intended to guide the run of the cable harness inside the housing (6), the housing (6) comprising a bottom (18a) extending along a plane substantially parallel to the printed circuit plane (YZ), a first rib (51) extending from the bottom (18a) of the housing (6) parallel to the axis at right angles to the printed circuit plane (YZ), the housing (6) comprising a lateral edge (18c) extending along a plane substantially at right angles to the printed circuit plane (YZ), a second rib extending from the lateral edge (18c) of the housing (6) parallel to the printed circuit plane (YZ).

5. Lighting device (11) according to one of the preceding claims, **characterized in that** the electrical cable harness (26) comprises an electromagnetic shielding, notably a ferrite core.

6. Lighting device (11) according to one of the preceding claims, **characterized in that** it comprises a rear optical assembly (19) comprising at least one collimator, notably a collimator of Fresnel type, and a front optical assembly (20), distinct from the rear optical assembly (19), provided with a front face comprising at least two transverse lighting surfaces (21) arranged at different levels in the longitudinal direction (X) to form at least two treads of an overall staircase form, the front optical assembly (20) being stacked in direct contact with the rear optical assembly (19).

7. Lighting device (11) according to the preceding claim, **characterized in that** the rear optical assembly (19) and the front optical assembly (20) each take the form of a single single-piece part each comprising at least one securing means.

8. Motor vehicle (1) comprising a lighting device (11) according to one of the preceding claims.

9. Method for mounting a lighting device (11) according to one of Claims 1 to 7 comprising the following steps:
a. production of a printed circuit (22) provided with an electromagnetic shielding cage (29) and provided with at least one light source (23), notably a light source (23) of light-emitting diode type;
b. production of an electrical cable harness (26);
c. production of a housing (6) provided with a first rib (51) and a second rib (52), notably production of the housing (6) by plastic injection moulding;
d. fixing of a first end of the electrical cable harness (26) to the housing (6);
e. fixing of a second end of the electrical cable harness (26) to the printed circuit (22);
f. positioning of the electrical cable harness (26) between a first rib (51) and a lateral edge (18c) of the housing (6), and/or
g. positioning of the electrical cable harness (26) between a second rib (52) and an edge (18a) of the housing (6);
h. fixing of the printed circuit (22) inside the housing (6).

10. Mounting method according to the preceding claim, **characterized in that**:
- the step "f" is performed after the step "d" and after the step "e"; and/or
- the step "g" is performed after the step "d" and after the step "e"; and/or
- the step "h" is performed after the step "f" and after the step "g".
